# EUROPÄISCHE PATENTSCHRIFT

(11) **EP 0 829 121 B1**
(45) Veröffentlichungstag und Bekanntmachung des Hinweises auf die Patenterteilung: **28.10.1998**
(21) Anmeldenummer: 96914857.6
(22) Anmeldetag: 13.05.1996
(51) Int. Cl.: H01S 3/085, H01S 3/19

(54) **DFB-LASERDIODENSTRUKTUR MIT KOMPLEXER OPTISCHER GITTERKOPPLUNG**
DFB LASER DIODE STRUCTURE WITH COMPLEX OPTICAL GRATING COUPLING
STRUCTURE DE DIODE LASER A REACTION DISTRIBUEE A COUPLAGE PAR RESEAU OPTIQUE COMPLEXE

(30) Priorität: 31.05.1995 DE 19520043
(43) Veröffentlichungstag der Anmeldung: 18.03.1998
(73) Patentinhaber: SIEMENS AKTIENGESELLSCHAFT, 80333 München (DE)
(72) Erfinder: BORCHERT, Bernd, D-85368 Moosburg (DE); STEGMÜLLER, Bernhard, D-86163 Augsburg (DE)
(86) Internationale Anmeldenummer: DE9600837
(87) Internationale Veröffentlichungsnummer: WO9638890

(56) Entgegenhaltungen:
- EP-A- 0 507 956
- EP-A- 0 727 852
- IEEE PHOTONICS TECHNOLOGY LETTERS, Bd. 4, Nr. 7, 1.Juli 1992, Seiten 692-695, XP000289285 LUO Y ET AL: "Gain-coupled distributed feedback semiconductor lasers with an absorptive conduction-type inverted grating"
- IEEE JOURNAL OF QUANTUM ELECTRONICS, Bd. 30, Nr. 6, Juni 1994, Seiten 1370-1380, XP000461368 W.T.TSANG ET AL.: "Long-wavelength InGaAsP/InP multiquantum well distributed feedback and distributed Bragg reflector lasers grown by chemical beam epitaxy"
- ELECTRONICS LETTERS, Bd. 30, Nr. 1, 6.Januar 1994, Seite 39/40 XP000424685 ZOZ J ET AL: "Dynamic behaviour of complex-coupled DFB lasers with in-phase absorptive grating"

## Beschreibung

Die Erfindung betrifft eine DFB-Laserdiodenstruktur mit komplexer optischer Gitterkopplung nach dem Oberbegriff des Patentanspruchs 1.

Eine DFB-Laserdiodenstruktur der genannten Art ist aus IEEE Photonics Technology Letters, Bd. 4, Juli 1992, Seiten 692 - 695 oder EP-A-0 507 956 bekannt.

Aus der DE 41 24 872 A1 oder aus B. Borchert et al: Electronics Letters, Vol. 29 (1993) S. 210-211 ist eine DFB-Laserdiodenstruktur bekannt, die bis auf die Merkmale, daß die Schicht aus dem Indexmaterial und die Schicht aus dem Absorptionshalbleitermaterial jeweils aus Volumenmaterial bestehen und sich sowohl die Schicht aus dem Volumen-Indexmaterial als auch die Schicht aus dem Volumen-Absorptionshalbleitermaterial zwischen der einen Mantelschicht und der Reliefoberläche in den Vorsprüngen des Gitters befinden,.alle Merkmale einer Laserdiodenstruktur der eingangs genannten Art aufweist.

Bei dieser bekannten Struktur ist die Schicht aus dem Indexhalbleitermaterial in den definierten Vorsprüngen des optischen Gitters vorhanden, die Schicht aus dem Absorptionshalbleitermaterial befindet sich dagegen nur in den definierten Rücksprüngen dieses Gitters.

Diese Vorsprünge und Rücksprünge sind im Profil beispielsweise dreieckförmig ausgebildet. Dabei sollte die für die komplexe Gitterkopplung notwendige Schicht aus dem Absorptionshalbleitermaterial nur in den Spitzen der dreieckförmigen Rücksprünge des holografisch hergestellten Gitters ausgebildet sein. Dadurch hängt die Wirkung der komplexen Kopplung entscheidend davon ab, wie reproduzierbar die Gitterform des ein Bragg-Gitter bildenden Gitters hergestellt werden kann. Schwankungen in der Gitterform, die durch unvermeidliche Schwankungen der Technologieprozessparameter während der Gitterherstellung auftreten können, wirken sich bei dieser Realisierungsform der komplexen Kopplung deshalb besonders stark auf die Stärke der komplexen Kopplung und damit auf die spektralen Eigenschaften der DFB-Lasersdiodentruktur aus.

Durch die im Anspruch 1 angegebene erfindungsgemäße DFB-Laserdiodenstruktur mit komplexer Gitterkopplung wird vorteilhafterweise eine verbesserte Reproduzierbarkeit der Gitterstruktur bei der Herstellung erreicht. Überdies wird bei der erfindungsgemäßen Laserdiodenstruktur gegenüber der in der in der DE 41 24 872 A1 oder bei B. Borchert et al beschriebenen Diodenstruktur vorteilhafterweise eine verbesserte Monomodeausbeute und Monomde-Emission über einen großen Temperaturbereich erhalten. Spektral einmodige DFB-Laserdiodenstrukturen sind Schlüsselkomponenten der optischen Nachrichtentechnik.

Die erfindungsgemäße Laserdiodenstruktur hat außerdem den Vorteil, daß eine relativ große Designfreiheit bei der Herstellung der komplexen Kopplungsstärke durch Verwendung der Volumenmaterialien besteht und eine bessere Langzeitstabilität durch wenige Grenzflächen, an denen Schichten aneinandergrenzen, erhalten werden kann.

Volumenmaterial bedeutet, daß die aus einem solchen Material bestehende Schicht so dick ist, daß keine Quanteneffekte auftreten, wie dies bei dünnen Quantum-Well-Schichten der Fall ist.

Die erfindungsgemäße Laserdiodenstruktur hat außerdem den Vorteil der Realisierungsmöglichkeit eines technologietoleranten vergrabenen Gitters und der Möglichkeit einer gleichzeitigen Realisierung eines Gitters aus Indexhalbleitermaterial und eines Gitters aus Absorptionshalbleitermaterial.

Indexhalbleitermaterial und Absorptionshalbleitermaterial bedeuten, daß das Indexhalbleitermaterial für das betreffende Licht durchlässiger als das Absorptionshalbleitermaterial ist und das Absorptionshalbleitermaterial dieses Licht stärker absorbiert als das Indexhalbleitermaterial. Beim Indexhalbleitermaterial herrscht der Realteil des komplexen Brechungsindex gegenüber dem Imaginärteil vor, während beim Absorptionshalbleitermaterial der Imaginärteil gegenüber dem Realteil vorherrscht.

Es sei darauf hingewiesen, daß es aus G.P. Li et al., Electronics Letters, Vol. 28 (1992), S. 1726-1727 bekannt ist, ein Gewinngitter zu realisieren, indem das Bragg-Gitter in die aus einer Multi-Quantum-Well-Struktur (MQW-Struktur) bestehende aktive Schicht der Laserdiodenstruktur geätzt wird. Dadurch, daß bei dieser Laserdiodenstruktur die aktive Schicht ganzflächig strukturiert wird, besteht die Gefahr mangelnder Langzeitstabilität.

Aus W. T. Tsang et al., Applied Physics Letters, Vol. 60 (1992), S. 2580-2582 ist es bekannt, die komplexe Kopplung durch das Ätzen des Bragg-Gitters in eine zweite MQW-Struktur zu erreichen, die zusätzlich zur aktiven MQW-Schicht dieser Laserdiodenstruktur entweder unterhalb oder oberhalb dieser letztgenannten Schicht und damit außerhalb des pn-Übergangs dieser Diodenstruktur liegt. Durch entsprechendes Design dieser MQW-Struktur kann entweder ein Gitter aus Indexhalbleitermaterial oder ein Gitter aus Absorptionshalbleitermaterial realisiert werden. Diese Gitterstruktur kann auch vergraben sein, wodurch die bei der oben näher bezeichneten bekannten Laserdiodenstruktur nach dem Oberbegriff des Patentanspruchs 1 vorhandene starke Abhängigkeit der komplexen Kopplungsstärke von den Technologieprozeßparametern verringert werden kann. Allerdings weist die Laserdiodenstruktur nach Tsang et al. viele Grenzflächen der zweiten ganzflächig strukturierten MQW-Struktur auf, die zu Langzeitstabilitätsproblemen führen, sowie einen eingeschränkten, durch Design einstellbaren Parameterraum in der komplexen Gitterkopplung, der durch die dünnen MQW-Schichten bedingt ist.

Die erfindungsgemäße Laserdiodenstruktur verbindet den bei der Struktur nach der DE 41 24 872 A1 und der Struktur nach Borchert et al. jeweils ebenfalls vorhandenen Vorteil der relativ großen Designfreiheit in der Einstellung der komplexen Kopplungsstärke durch Verwendung dicker Volumenmaterialien und der potentiell besseren Langzeitstabilität durch wenige Grenzflächen mit dem bei der Struktur nach Chang et al vorhandenen Vorteil der Realisierungsmöglichkeit eines technologietoleranten vergrabenen Gitters und der gleichzeitigen Realisierung eines Gitters aus Indexhalbleitermaterial und eines Gitters aus Absorptionshalbleitermaterial. Gleichzeitig hängt vorteilhafterweise die Wirkung der komplexen Kopplung nicht wie bei der Struktur nach der DE 41 24 872 A1 oder Borchert et al. davon ab, wie reproduzierbar die Gitterform des Bragg-Gitters hergestellt werden kann, und sind vorteilhafterweise nicht wie bei der Struktur nach Chang et al viele Grenzflächen der zweiten MQW-Struktur, die potentielle Langzeitstabilitätsprobleme verursachen und nicht der durch die dünnen MQW-Schichten bedingte eingeschränkte, durch Design einstellbare Parameterraum in der komplexen Gitterkopplung vorhanden.

Das erfindungsgemäße Verfahren ist für die Herstellung von komplex gekoppelten DFB-Laserdioden mit Monomodeemission bei 1,3 µm und 1,55 µm Wellenlänge bis 100°C und insbesondere zur Herstellung von schnellen, billigen DFB-Lasermodulen geeignet.

Bevorzugte und vorteilhafte Ausgestaltungen der erfindungsgemäßen Laserdiodenstruktur gehen aus den Unteransprüchen hervor.

Die Erfindung wird in der nachfolgenden Beschreibung anhand der Figuren beispielhaft näher erläutert.

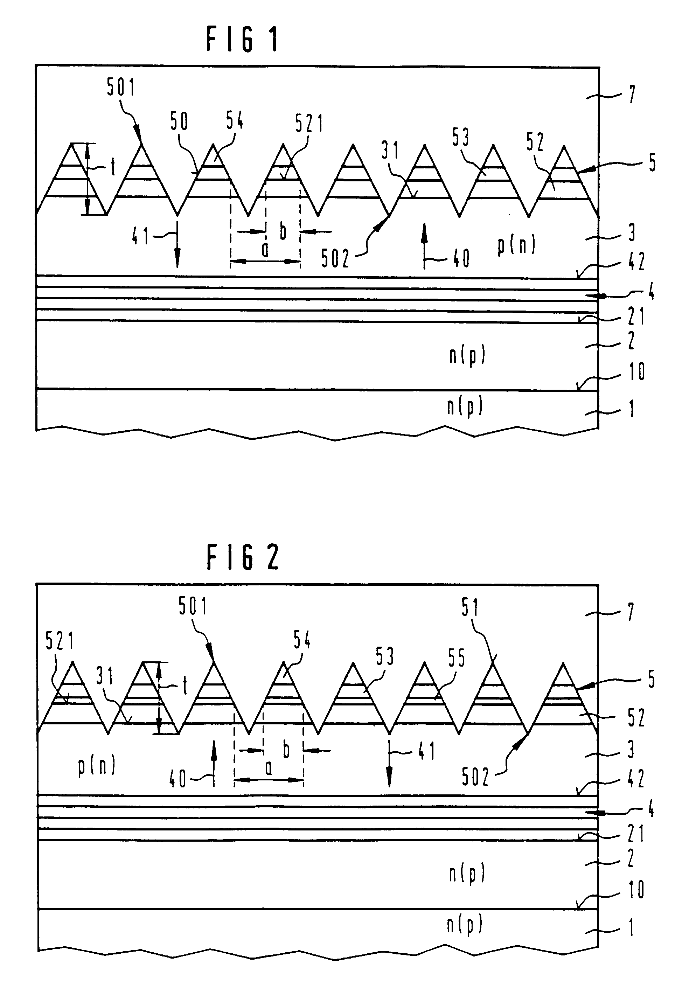

Die Figuren 1 bis 4 zeigen in der jeweils gleichen Querschnittsdarstellung vier Ausführungsvarianten der erfindungsgemäßen Laserdiodenstruktur. Die Figuren sind schematisch und nicht maßstäblich.

Bei den beiden Varianten nach den Figuren 1 und 2 ist auf der Oberfläche 10 eines Substrats 1 aus Halbleitermaterial eines Leitfähgikeitstyps, beispielsweise des einer n-Dotierung entsprechenden Typs, eine Mantelschicht 2 aus Halbleitermaterial des gleichen Leitfähigkeitstyps n aufgebracht. Auf der vom Substrat 1 abgekehrten Seite 21 der Mantelschicht 2 ist auf der Mantelschicht 2 eine laseraktive Schicht 4 aufgebracht. Die laseraktive Schicht 4 kann aus Volumenmaterial bestehen oder ein Quantum-Well-Schicht aufweisen, beispielsweise eine MQW-Schicht sein, wie zeichnerisch angedeutet ist.

Auf der von der Mantelschicht 2 abgekehrten Seite 41 der laseraktiven Schicht 4 ist eine Mantelschicht 3 aus Halbleitermaterial des zum Material der Mantelschicht 2 entgegengesetzten Leitfähigkeitstyps, im angenommenen Beispiel des einer p-Dotierung entsprechenden Typs, auf der laseraktiven Schicht 4 aufgebracht. Prinzipiell könnten auch die Mantelschicht 3 vom Leitfähigkeitstyp n und die Mantelschicht 2 und das Substrat 1 und vom Leitfähigkeitstyp p und sein.

Unter vorläufiger Nichtbeachtung des später zu beschreibenden Gitters 5 ist auf der von der laseraktiven Schicht 4 abgekehrten Seite 31 der Mantelschicht 3 eine Schicht 52 aus Indexhalbleitermaterial auf der Mantelschicht 3 aufgebracht. Auf der von der Mantelschicht 3 abgekehrten Seite 521 der Schicht 52 aus dem Indexhalbleitermaterial ist eine Schicht 53 aus einem Absorptionshalbleitermaterial auf der Schicht 52 aus dem Indexhalbleitermaterial aufgebracht.

In der Schicht 52 aus dem Indexhalbleitermaterial und der Schicht 53 aus dem Absorptionshalbleitermaterial ist das optisches Gitter 5 in Form einer von der laseraktiven Schicht 4 abgekehrten Reliefoberfläche 50 ausgebildet. Die Reliefoberfläche 50 definiert in Richtung 40 von der einen Mantelschicht 3 fortweisende Vorsprünge 501 und in der entgegengesetzten Richtung 41 zur einen Mantelschicht 3 weisende Rücksprünge 502 des Gitters 5.

Erfindungsgemäß besteht sowohl die Schicht 52 aus dem Indexhalbleitermaterial als auch die Schicht 53 aus dem Absorptionshalbleitermaterial aus Volumenmaterial und überdies befinden sich sowohl die Schicht 52 aus dem Volumen-Indexhalbleitermaterial als auch die Schicht 53 aus dem Volumen-Absorptionshalbleitermaterial zwischen der einen Mantelschicht 3 und der Reliefoberfläche 50 in den Vorsprüngen 501 des Gitters 5.

Beispielsweise sind die Vorsprünge 501 und Rücksprünge 502 des Gitters 5 langgestreckt ausgebildet und so angeordnet, daß ihre Längsachse senkrecht zur Zeichenebene steht. Außerdem weisen die Vorsprünge 501 und Rücksprünge 502 jeweils ein dreieckförmiges Profil auf, so wie es in den Figuren dargestellt ist.

Die Tiefe t der Rücksprünge 502 muß mindestens so groß sein, daß wenigstens die Schicht 53 aus dem Volumen-Absorptionsmaterial unterbrochen wird. Vorzugsweise sind die Rücksprünge 502 aber so tief, daß sowohl die Schicht 53 aus dem Volumen-Absorptionshalbleitermaterial als auch die Schicht 52 aus dem Volumen-Indexhalbleitermaterial unterbrochen wird. Die beiden Schichten 53 und 52 bilden in diesem Beispielfall parallele, im konstanten Abstand nebeneinander angeordnete Streifen mit einer zur Zeichenebene senkrecht stehenden Längsachse und einer mittleren Breite b, die selbst als ein optisches Gitter mit einer Gitterkonstanten a aufgefaßt werden können.

Die Struktur nach der Figur 1 und die Struktur nach der Figur 2 unterscheiden sich im wesentlichen dadurch voneinander, daß bei der Struktur nach Figur 1 die Schicht 52 aus dem Volumen-Indexhalbleitermaterial und die Schicht 53 aus dem Volumen-Absorptionshalbleitermaterial unmittelbar aneinandergrenzen und bei der Struktur nach Figur 2 die Schicht 52 aus dem Volumen-Indexhalbleitermaterial und die Schicht 53 aus dem Volumen-Absorptionshalbleitermaterial durch eine dünne Abstandsschicht 55 aus einem vorzugsweise eigenleitenden Halbleitermaterial voneinander getrennt sind.

Zur Realisierung eines vergrabenen Gitters 5, bei dem eine verbesserte Reproduzierbarkeit in der Gitterherstellung gegeben ist, befindet sich zwischen den Schichten 52 und 53 aus dem Index- und Absorptionshalbleitermaterial in Form von Volumenmaterial und der Reliefoberfläche 50 eine weitere Schicht 54 aus einem vorzugsweise eigenleitenden Halbleitermaterial in Form von Volumenmaterial befindet, die wie die Schichten 52 und 53 in den Vorsprüngen 501 des Gitters 5 ausgebildet ist. Diese weitere Schicht 54 dient zum epitaktischen Aufwachsen einer an die Reliefoberfläche angrenzenden Schicht 7 aus einem Halbleitermaterial in Form von Volumenmaterial des gleichen Leitfähigkeitstyps p wie die Mantelschicht 3, wobei das Volumenmaterial der Schicht 7 das Volumenmaterial der weiteren Schicht 54 ist.

Das durch die Schicht 7 erzeugte vergrabene Gitter 5 hat den Vorteil, daß ein Gitter 5 mit einem Tastverhältnis b/a von 50 % eingestellt werden kann, das eine maximale Unempfindlichkeit gegen technologisch bedingte Schwankungen in der Gitterform gewährleistet.

Die Schicht 53 aus dem Absorptionshalbleitermaterial ist vorzugsweise zwischen der Schicht 52 aus dem Indexhalbleitermaterial und der weiteren Schicht 54 bzw. der Reliefoberfläche 50 angeordnet.

Um mögliche Instabilitäten der komplex gekoppelten DFB-Laserdiodenstruktur zu vermeiden, sind die Schicht 52 aus dem Indexhalbleitermaterial und die Schicht 53 aus dem Absorptionshalbleitermaterial vom zueinander entgegengesetzten Leitfähigkeitstyp. Dabei ist es zweckmäßig, wenn die Schicht 52 aus dem Indexhalbleitermaterial vom gleichen Leitfähigkeitstyp wie die eine Mantelschicht 3, im Beispielsfall vom Typ p ist.

Die erfindungsgemäße Laserdiodenstruktur nach den Figuren 1 und 2 läßt sich vorteilhafterweise in nur zwei Epitaxieschritten herstellen, wobei die erste Epitaxie alle Schichten bis einschließlich zur weiteren Schicht 54 erzeugt. Die zweite Epitaxie ist im wesentlichen die Überwachsung des Gitters 5 mit der Schicht 7.

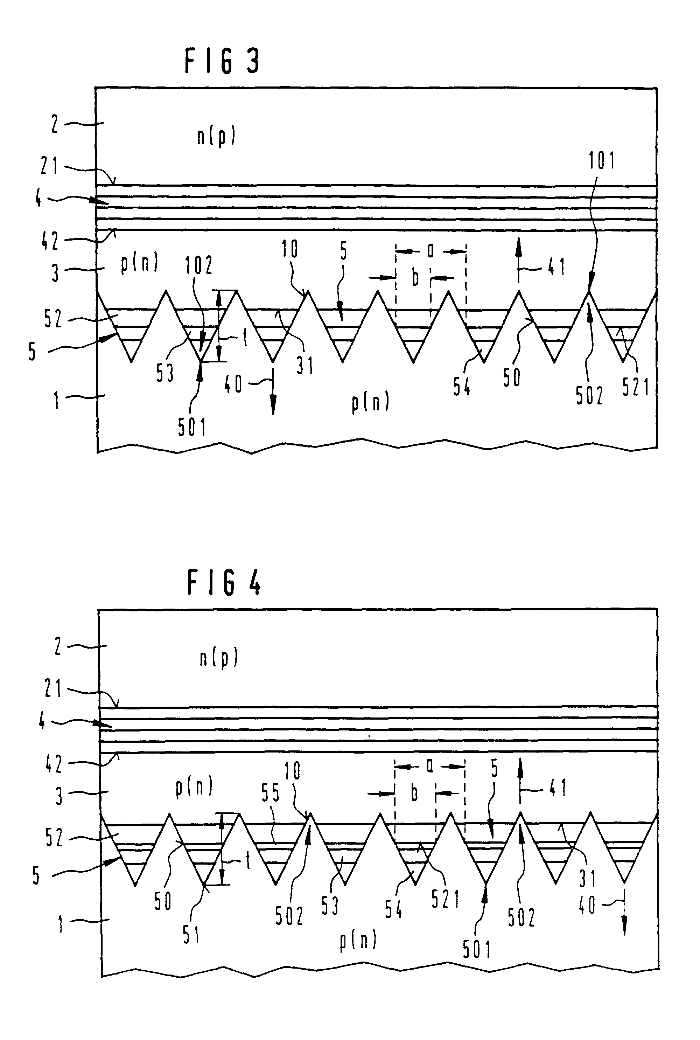

Die beiden erfindungsgemäßen Laserdiodenstrukturen nach den Figuren 3 und 4 unterscheiden sich von den erfindungsgemäßen Laserdiodenstrukturen nach den Figuren 1 und 2 dadurch, daß sich auf der von der laseraktiven Schicht 4 abgekehrten und das Gitter 5 bildenden Reliefoberfläche 50 ein an diese Reliefoberfläche angrenzender Körper nicht in Form der Schicht 7 nach den Figuren 1 und 2, sondern in Form des Substrats 1 aus dem Halbleitermaterial des Leitfähigkeitstyps der Schicht 52 aus dem Indexhalbleitermaterial befindet, wobei dieses Substrat 1 eine der Reliefoberfläche 50 gegenüberliegende Substratoberfläche 10 in Form eines zu dieser Reliefoberfläche 50 komplementären Reliefs aufweist.

Komplementär bedeutet in diesem Zusammenhang, daß die Substratoberfläche 10 genau dort in Richtung 41 zur laseraktiven Schicht 4 weisende Vorsprünge 101 aufweist, wo die Reliefoberfläche 50 in Richtung 41 zur laseraktiven Schicht 4 weisende Vertiefungen aufweist, und genau dort in Richtung 40 von der laseraktiven Schicht 4 weisende Rücksprünge 102 aufweist, wo die Reliefoberfläche 50 in Richtung 40 von der laseraktiven Schicht 4 weisende Vorsprünge 501 aufweist. Dementsprechend ragt in jeden Rücksprung 102 des Substrats 1 ein Vorsprung 501 der Reliefoberfläche 50 und in jeden Rücksprung 502 der Reliefoberfläche 50 ein Vorsprung der Substratoberfläche 10.

Alle übrigen Teile der Strukturen nach den Figuren 3 und 4, die zu Teilen der Strukturen nach den Figuren 1 und 2 gleich sind, sind mit den gleichen Bezugszeichen versehen. Die Beschreibung solcher Teile ist bereits im Zusammenhang mit den Figuren 1 und 2 beschrieben worden und wird nicht wiederholt.

Die Struktur nach Figur 3 unterscheidet sich von der Struktur nach Figur 4 genauso wie die Struktur nach Figur 1 von der Struktur nach Figur 2, d.h. bei der Struktur nach Figur 3 grenzen die Schicht 52 aus dem Indexhalbleitermaterial und die Schicht 53 aus dem Absorptionshalbleitermaterial unmittelbar aneinander, während bei der Struktur nach Figur 4 diese Schichten 52 und 53 durch eine dünne Abstandsschicht 55 voneinander getrennt sind.

Ein geringfügiger Unterschied zwischen den Strukturen nach den Figuren 3 und 4 und den Strukturen nach den Figuren 1 und 2 liegt überdies darin, daß unter der Annahme, daß bei allen Strukturvarianten die Mantelschicht 2 vom Leitfähigkeitstyp n ist, das Substrat 1 bei den Strukturen nach den Figuren 1 und 2 ebenfalls vom Typ n sein muß, während bei den Strukturen nach den Figuren 3 und 4 das Substrat 1 vom Leitfähigkeitstyp p sein muß. Die Verhältnisse kehren sich um, wenn bei allen Strukturvarianten die Mantelschicht 2 vom Leitfähigkeitstyp p ist.

Ein weiterer Unterschied besteht noch darin, daß bei den Strukturen nach den Figuren 3 und 4 die Schicht 54 nicht so notwendig ist, wie bei den Strukturen nach den Figuren 1 und 2, weil die Schichten 53 und 52 unmittelbar auf die Substratoberfläche 10 aufgewachsen werden können.

Die Strukturen nach den Figuren 3 und 4 haben den Vorteil, daß bei der Herstellung dieser Struktur nur eine Epitaxie erforderlich ist. Zunächst wird die Substratoberfläche 10 so strukturiert, daß sie die Vorsprünge 101 und die Rücksprünge 102 aufweist und dann werden sämtliche Schichten mit einer einzigen Epitaxie aufgewachsen. Bei Verwendung der Schicht 54 können die Wachstumsparamter bei der Epitaxie so eingestellt werden, daß die Schicht 54 nicht nur in den Spitzen der Rücksprünge 102 vorhanden ist, sondern die ganze Substratoberfläche 10 bedeckt.

Bei einem bevorzugten Ausführungsbeispiel der Strukturen nach den Figuren 1 und 2 besteht das Substrat aus n-dotiertem InP, die Mantelschicht aus n-dotiertem InP, die aktive Schicht 4 aus einer MQW-Struktur, die Mantelschicht 3 aus p-dotiertem InP, die Schicht 52 aus p-dotiertem InGaAsP, die Schicht 53 aus n-dotiertem InGaAs, die weitere Schicht 54 aus aus InP und die Schicht 7 aus p-dotiertem InP. Die Abstandsschicht 55 besteht aus InP.

Bei einem Ausführungsbeispiel der Strukturen nach den Figuren 3 und 4 besteht das Substrat 1 aus p-dotiertem InP, die Schicht 54 aus InP, die Schicht 53 aus n-dotiertem InGaAs, die Schicht 52 aus p-dotiertem InGaAsP, die Mantelschicht 3 aus p-dotiertem InP, die aktive Schicht 4 aus einer MQW-Struktur und die Mantelschicht 2 aus n-dotiertem InP.

### Die Abstandsschicht 55 besteht aus InP.

Bei diesen Ausführungsbeispielen könnte bei 1,55 µm Wellenlänge das quaternäre InGaAsP der Schicht 53 eine Bandgapwellenlänge von 1,15 µm aufweisen, während das ternäre InGaAs der Schicht 53 aus Volumen-Absorptionshalbleitermaterial eine Bandgapwellenlänge von 1,66 µm aufweisen könnte.

## Patentansprüche

1. DFB-Laserdiodenstruktur mit komplexer optischer Gitterkopplung, bestehend aus
- einer zwischen zwei optischen Mantelschichten (2, 3) aus Halbleitermaterial zueinander entgegengesetzten Leitfähigkeitstyps (n, p) angeordneten laseraktiven Schicht (4),
- einer Schicht (52) aus einem Indexhalbleitermaterial in Form von Volumenmaterial, die auf einer von der laseraktiven Schicht (4) abgekehrten Seite (31) einer (3) der beiden Mantelschichten (2, 3) angeordnet ist,
- einer Schicht (53) aus einem Absorptionshalbleitermaterial in Form von Volumenmaterial, die auf einer von der einen Mantelschicht (3) abgekehrten Seite (521) der Schicht (52) aus Indexhalbleitermaterial angeordnet ist,
- einem in der Schicht (52) aus dem Indexhalbleitermaterial und der Schicht (53) aus dem Absorptionshalbleitermaterial ausgebildeten optischen Gitter (5) in Form einer von der laseraktiven Schicht (4) abgekehrten Reliefoberfläche (50), die in Richtung (40) von der laseraktiven Schicht (4) weisende Vorsprünge (501) und in Richtung (41) zur laseraktiven Schicht (4) weisende Rücksprünge (502) des Gitters (5) definiert, wobei
- die Schicht (52) aus dem Indexhalbleitermaterial und die Schicht (53) aus einem Absorptionshalbleitermaterial zueinander entgegengesetzten Leitfähigkeitstyps (p, n) sind,
- sich sowohl die Schicht (52) aus dem Indexhalbleitermaterial als auch die Schicht (53) aus dem Absorptionshalbleitermaterial zwischen der einen Mantelschicht (3) und der Reliefoberläche (50) in den Vorsprüngen (501) des Gitters (5) befinden, und
- sich auf der von der laseraktiven Schicht (4) abgekehrten Seite der Reliefoberfläche (50) ein an die Reliefoberfläche (50) angrenzender Körper (7; 1) aus Halbleitermaterial vom Leitfähigkeitstyp (p; n) der einen Mantelschicht (3) befindet,
**dadurch gekennzeichnet,** daß sich in den Vorsprüngen (501) des Gitters (5) zwischen den Schichten (52, 53) aus dem Absorptions- und Indexhalbleitermaterial und der Reliefoberfläche (50) eine weitere Schicht (54) aus vom Indexhalbleitermaterial und Absorptionshalbleitermaterial verschiedenem Halbleitermaterial in Form von Volumenmaterial befindet, und daß der an die Reliefoberfläche (50) angrenzende Körper (7; 1) aus dem gleichen Halbleitermaterial wie die weitere Schicht (54) besteht.

2. Laserdiodenstruktur nach Anspruch 1, **dadurch gekennzeichnet,** daß die Schicht (52) aus dem Indexhalbleitermaterial vom gleichen Leitfähigkeitstyp (p) wie die eine Mantelschicht (3) ist.

3. Laserdiodenstruktur nach einem der vorhergehenden Ansprüche, **dadurch gekennzeichnet,** daß sich die Schicht (53) aus dem Absorptionshalbleitermaterial zwischen der Schicht (52) aus dem Indexhalbleitermaterial und der weiteren Schicht (54) befindet.

4. Laserdiodenstruktur nach einem der vorhergehenden Ansprüche, **dadurch gekennzeichnet**, daß die weitere Schicht (54) aus eigenleitendem Halbleitermaterial besteht.

5. Laserdiodenstruktur nach einem der vorhergehenden Ansprüche, **dadurch gekennzeichnet,** daß die Schicht (52) aus dem Indexhalbleitermaterial und die Schicht (53) aus dem Absorptionshalbleitermaterial aneinandergrenzen.

6. Laserdiodenstruktur nach einem der Ansprüche 1 bis 4, **dadurch gekennzeichnet**, daß die Schicht (52) aus dem Indexhalbleitermaterial und die Schicht (53) aus dem Absorptionshalbleitermaterial durch eine Abstandsschicht (55) aus einem eigenleitenden Halbleitermaterial voneinander getrennt sind.

7. Laserdiodenstruktur nach einem der vorhergehenden Ansprüche **dadurch gekennzeichnet,** daß der an die Reliefoberfläche (50) angrenzende Körper aus einer Schicht (7) aus Volumenmaterial besteht.

8. Laserdiodenstruktur nach einem der vorhergehenden Ansprüche **dadurch gekennzeichnet**, daß der an die Reliefoberfläche (50) angrenzende Körper aus einem Substrat (1) mit einer der Reliefoberfläche (50) gegenüberliegenden Substratoberfläche (10) in Form eines zur Reliefoberfläche (50) komplementären Reliefs besteht.

9. Laserdiodenstruktur nach einem der vorhergehenden Ansprüche, **dadurch gekennzeichnet,** daß das Gitter (5) im Bereich der Schicht (52) aus dem Indexhalbleitermaterial ein Tastverhältnis (b/a) von im wesentlichen 50% aufweist.

10. Laserdiodenstruktur nach einem der vorhergehenden Ansprüche, **dadurch gekennzeichnet**, daß das Halbleitermaterial der beiden Mantelschichten (2, 3) aus InP, das Indexhalbleitermaterial aus InGaAsP, das Absorptionshalbleitermaterial aus InGaAs besteht und das Halbleitermaterial der weiteren Schicht (54) aus InP besteht.

11. Laserdiodenstruktur nach Anspruch 7 und 10, **dadurch gekennzeichnet,** daß die Abstandsschicht (55) aus InP besteht.

## Claims

1. DFB laser diode structure having complex optical grating coupling, comprising
- a laser-active layer (4) arranged between two optical cladding layers (2, 3) made from semiconductor material of mutually opposite conductivity types (n, p),
- a layer (52) which is made from an index semiconductor material in the form of volumetric material and is arranged on a side (31), averted from the laser-active layer (4), of one (3) of the two cladding layers (2, 3),
- a layer (53) which is made from an absorption semiconductor material in the form of volumetric material and is arranged on a side (521), averted from the one cladding layer (3), of the layer (52) made from index semiconductor material,
- an optical grating (5) constructed in the layer (52) made from the index semiconductor material and the layer (53) made from the absorption semiconductor material, in the form of a relief surface (50) which is averted from the laser-active layer (4) and defines forward projections (501) of the grating (5) pointing in the direction (40) away from the laser-active layer (4) and backward projections (502) of the grating (5) pointing in the direction (41) towards the laser-active layer (4),
- the layer (52) made from the index semiconductor material and the layer (53) made from an absorption semiconductor material being of mutually opposite conductivity types (p, n),
- both the layer (52) made from the index semiconductor material and the layer (53) made from the absorption semiconductor material being located between the one cladding layer (3) and the relief surface (50) in the forward projections (501) of the grating (5), and
- there being located on the side, averted from the laser-active layer (4), of the relief surface (50) a body (7; 1) which abuts the relief surface (50) and is made from semiconductor material of the conductivity type (p; n) of the one cladding layer (3), characterized in that there is located in the forward projections (501) of the grating (5) between the layers (52, 53) made from the absorption semiconductor material and the index semiconductor material and the relief surface (50) a further layer (54) which is made from a semiconductor material differing from the index semiconductor material and absorption semiconductor material and is in the form of volumetric material, and in that the body (7; 1) which abuts the relief surface (50) comprises the same semiconductor material as the further layer (54).

2. Laser diode structure according to Claim 1, characterized in that the layer (52) made from the index semiconductor material is of the same conductivity type (p) as the one cladding layer (3).

3. Laser diode structure according to one of the preceding claims, characterized in that the layer (53) made from the absorption semiconductor material is located between the layer (52) made from the index semiconductor material and the further layer (54).

4. Laser diode structure according to one of the preceding claims, characterized in that the further layer (54) comprises intrinsic semiconductor material.

5. Laser diode structure according to one of the preceding claims, characterized in that the layer (52) made from the index semiconductor material and the layer (53) made from the absorption semiconductor material abut one another.

6. Laser diode structure according to one of Claims 1 to 4, characterized in that the layer (52) made from the index semiconductor material and the layer (53) made from the absorption semiconductor material are separated from one another by a spacer layer (55) made from an intrinsic semiconductor material.

7. Laser diode structure according to one of the preceding claims, cnaracterized in that the body which abuts the relief surface (50) comprises a layer (7) made from volumetric material.

8. Laser diode structure according to one of the preceding claims, characterized in that the body which abuts the relief surface (50) comprises a substrate (1) having a substrate surface (10) which is opposite the relief surface (50) and is in the form of a relief complementary to the relief surface (50).

9. Laser diode structure according to one of the preceding claims, characterized in that in the region of the layer (52) made from the index semiconductor material the grating (5) has a pulse duty factor (b/a) of essentially 50%.

10. Laser diode structure according to one of the preceding claims, characterized in that the semiconductor material of the two cladding layers (2, 3) comprises InP, the index semiconductor material comprises InGaAsP, the absorption semiconductor material comprises InGaAs and the semiconductor material of the further layer (54) comprises InP.

11. Laser diode structure according to Claims 7 and 10, characterized in that the spacer layer (55) comprises InP.

## Revendications

1. Structure de diode laser DFB à couplage par réseau optique complexe, constituée
- d'une couche active de laser (4) disposée entre deux couches d'enveloppe optiques (2, 3) en matériau semi-conducteur d'un type de conductibilité opposé l'un à l'autre (n, p),
- d'une couche (52) en matériau d'indexation semi-conducteur sous forme de matériau volumique, disposée sur une face (31) éloignée de la couche active de laser (4) de l'une (3) des deux couches d'enveloppe (2, 3),
- d'une couche (53) en matériau absorbant semi-conducteur sous forme de matériau volumique, disposée sur l'une des faces (521) éloignée de l'une des couches d'enveloppe (3) de la couche (52) en matériau d'indexation semi-conducteur,
- d'un réseau optique (5) formé dans la couche (52) en matériau d'indexation semi-conducteur et dans la couche (53) en matériau absorbant semi-conducteur, sous la forme d'une surface en relief (50) éloignée de la couche active de laser (4), qui définit des saillies (501) s'étendant en direction (40) à partir de la couche active de laser (4) et des retraits (502) s'étendant en direction (41) vers la couche active de laser (4), du réseau (5).
- la couche (52) en matériau d'indexation semi-conducteur et la couche (53) en matériau absorbant semi-conducteur étant d'un type de conductibilité opposé l'un à l'autre (p, n),
- tant la couche (52) en matériau d'indexation semi-conducteur que la couche (53) en matériau absorbant semi-conducteur se trouvant entre l'une des couches d'enveloppe (3) et la surface en relief (50) dans les saillies (501) du réseau (5), et
- un corps (7; 1) contigu à la surface en relief (50), en matériau semi-conducteur du type de conductibilité (p, n) de l'une des couches d'enveloppe (3) se trouvant à la face de la surface en relief (50) éloignée de la couche active de laser (4), caractérisé en ce qu'une autre couche (54) en matériau d'indexation semi-conducteur et de matériau absorbant semi-conducteur de différents matériaux semi-conducteurs sous forme de matériau volumique se trouve dans les saillies (501) du réseau (5) entre les couches (52, 53) en matériau absorbant et en matériau d'indexation semi-conducteur et la surface en relief 50, et en ce que le corps (7; 1) contigu à la surface en relief (50) est constitué du même matériau semi-conducteur que l'autre couche (54).

2. Structure de diode laser selon la revendication 1, caractérisée en ce que la couche (52) est constituée du même matériau d'indexation semi-conducteur du même type de conductibilité (p) que l'une des couches d'enveloppe (3).

3. Structure de diode laser selon l'une des revendications précédentes, caractérisée en ce que la couche (53) en matériau absorbant semi-conducteur se trouve entre la couche (52) en matériau d'indexation semi-conducteur et l'autre couche (54).

4. Structure de diode laser selon l'une des revendications précédentes, caractérisée en ce que l'autre couche (54) est constituée de matériau semi-conducteur autoconducteur.

5. Structure de diode laser selon l'une des revendications précédentes, caractérisée en ce que la couche (52) en matériau d'indexation semi-conducteur et la couche (53) en matériau absorbant semi-conducteur sont contiguës.

6. Structure de diode laser selon l'une des revendications 1 à 4, caractérisée en ce que la couche (52) en matériau d'indexation semi-conducteur et la couche (53) en matériau absorbant semi-conducteur sont séparées l'une de l'autre par une couche intercalaire (55) constituée d'un matériau semi-conducteur autoconducteur.

7. Structure de diode laser selon l'une des revendications précédentes, caractérisée en ce que le corps contigu à la surface en relief (50) est constitué d'une couche (7) en matériau volumique.

8. Structure de diode laser selon l'une des revendications précédentes, caractérisée en ce que le corps contigu à la surface en relief (50) est constitué d'un substrat (1) présentant une surface de substrat (10) opposée à la surface en relief (50), sous forme d'un relief complémentaire à la surface en relief (50).

9. Structure de diode laser selon l'une des revendications précédentes, caractérisée en ce que le réseau (5) présente dans la zone de la couche (52) en matériau d'indexation semi-conducteur un taux d'impulsions (b/a) de 50 % essentiellement.

10. Structure de diode laser selon l'une des revendications précédentes, caractérisée en ce que le matériau semi-conducteur des deux couches d'enveloppe (2, 3) est constitué d'lnP, le matériau d'indexation semi-conducteur d'lnGaAsP, le matériau d'absorption semi-conducteur d'lnGaAs et en ce que le matériau semi-conducteur de l'autre couche (54) est constitué d'lnP.

11. Structure de diode laser selon les revendications 7 et 10, caractérisée en ce que la couche intercalaire (55) est constituée d'lnP.
